# EUROPÄISCHE PATENTSCHRIFT

(11) **EP 3 041 653 B1**
(45) Veröffentlichungstag und Bekanntmachung des Hinweises auf die Patenterteilung: **11.10.2017**
(21) Anmeldenummer: 14747372.2
(22) Anmeldetag: 01.08.2014
(51) Int. Cl.: B29C 45/14, H05K 3/20, B29C 45/16

(54) **HINTERSPRITZTES LEITERBAHNSTANZGITTER UND VERFAHREN ZU DESSEN FERTIGUNG**
INSERT-MOULDED LEAD FRAME AND METHOD FOR THE PRODUCTION THEREOF
GRILLE ESTAMPÉE DE TRACÉS CONDUCTEURS SURMOULÉE PAR INJECTION ET PROCÉDÉ DE FABRICATION DE LADITE GRILLE

(30) Priorität: 03.09.2013 DE 102013217549
(43) Veröffentlichungstag der Anmeldung: 13.07.2016
(73) Patentinhaber: Robert Bosch GmbH, 70442 Stuttgart (DE)
(72) Erfinder: GERHAEUSSER, Martin, 74336 Brackenheim-Stockheim (DE); BARONE, Giuseppe, 71640 Ludwigsburg (DE)
(86) Internationale Anmeldenummer: PCT/EP2014/066640
(87) Internationale Veröffentlichungsnummer: WO 2015/032559

(56) Entgegenhaltungen:
- DE-A1- 19 804 607
- DE-A1-102009 047 051
- DE-A1-102010 019 027
- DE-C1- 3 612 576

## Beschreibung

### Gebiet der Erfindung

Die vorliegende Erfindung betrifft ein Leiterbahnstanzgitter, wie es insbesondere für eine Verschaltung einer in einem Fahrzeuggetriebe einsetzbaren Steuerung verwendet werden kann, sowie ein Verfahren zum Fertigen eines Leiterbahnstanzgitters.

### Stand der Technik

Leiterbahnstanzgitter werden beispielsweise im Kraftfahrzeugbau eingesetzt, um Steuergeräte elektrisch zu kontaktieren. Beispielsweise werden in Kraftfahrzeug-Automatikgetrieben zur Steuerung von Kupplungs- und Schaltvorgängen Steuermodule eingesetzt, die in einem ölgefüllten Getriebeinnenraum eingebaut sind. Für eine elektrische Leitungsführung werden dabei umspritzte Stanzgitter verwendet.

Leiterbahnstanzgitter sind vorzugsweise flache Elemente, auf denen auch elektronische Bauteile angebracht sein können. Es sind elektrisch leitende Abschnitte in Form singulärer Leiterbahnen auf den Leiterbahnstanzgittern vorhanden, insbesondere auf einem Kernelement, das zentral angeordnet und von einer elektrisch isolierenden Hülle umgeben ist. Das Kernelement ist dabei im Allgemeinen aus Kunststoff oder Metall hergestellt, wobei bei einer Kunststoffausführung die Leiterbahnen als leitende Schichten auf einem Trägersubstrat aufgebracht sind.

Die DE 10 2009 046 467 A1 beschreibt ein Leiterbahnstanzgitter mit einer speziellen Oberflächenkontur sowie ein Steuergerät mit einem solchen Leiterbahnstanzgitter. Es wird auch ein herkömmliches Verfahren zum Fertigen eines Leiterbahnstanzgitters beschrieben.

Kurz zusammengefasst werden in einem ersten Fertigungsschritt Kernelemente der Leiterbahnstanzgitter mittels Stanzverfahren gebildet. Dabei sind die einzelnen Kernelemente an einigen Stellen mechanisch miteinander verbunden, so dass nicht jedes einzelne Kernelement während eines nachfolgenden Umspritzungsvorganges in ein entsprechendes Werkzeug eingelegt werden muss.

Anschließend werden die Kernelemente mit einem Kunststoff umspritzt, um eine Hülle um die Kernelemente zu bilden und um hierdurch einerseits eine notwendige elektrische Isolierung nach außen zu gewährleisten und andererseits eine mechanische Stabilisierung zu erreichen.

Dabei findet in einem zweiten Fertigungsschritt ein teilweises Vorumspritzen in Form einer ersten Teilumspritzung der Kernelemente des Leiterbahnstanzgitters statt, bei dem jedoch Teilbereiche wie zum Beispiel die Verbindungsstellen, die die einzelnen Kernelemente zusammenhalten, meist nicht umspritzt werden. Diese Teilbereiche können Öffnungsbereiche bilden, die im Allgemeinen Abmessungen von 1 bis 2 mm aufweisen.

In einem dritten Fertigungsschritt werden die Kernelemente voneinander getrennt. Dabei werden die Verbindungsstellen zwischen den Kernelementen herausgestanzt oder anders getrennt. Es entsteht hierdurch eine Vielzahl einzelner Kernelemente bzw. Leiterbahnen, die miteinander im Regelfall nicht elektrisch verbunden sind. Die vorangehend geschaffene Vorumspritzung umschließt dabei im Allgemeinen mehrere Kernelemente und hält diese Kernelemente zusammen und in ihrer erforderlichen geometrischen Position.

In einem abschließenden vierten Fertigungsschritt findet ein Hauptumspritzen in Form einer zweiten Teilumspritzung der einzelnen vorumspritzten Kernelemente statt. Dabei werden insbesondere die durch die Vorumspritzung nicht bedeckten Bereiche des Leiterbahnstanzgitters umspritzt, aber auch die vorumspritzten Bereiche können teilweise umspritzt werden, sodass sich vorumspritzte und hauptumspritzte Bereiche teilweise seitlich überlappen können.

Um ein Verschieben einzelner Abschnitte der Kernelemente der Leiterbahnstanzgitter zueinander zu vermeiden und die gewünschte Position der Kernelemente zu gewährleisten, werden dabei im Umspritzungswerkzeug für die Hauptumspritzung notwendige Abstützbereiche auf der Vorumspritzung zur Anlage gebracht, so dass die Abstützbereiche eine Positionierung im Umspritzungswerkzeug für die Hauptumspritzung sicherstellen. Dies führt jedoch dazu, dass die Hauptumspritzung das Kernelement nicht vollständig umgeben kann, sondern zumindest an den genannten Abstützbereichen unterbrochen ist, so dass Teilbereiche der Vorumspritzung nicht bedeckt sind und nach außen hin freiliegen.

Bei herkömmlichen Leiterbahnstanzgittern wurde, insbesondere wenn diese zur Ausbildung von Steuerungen wie zum Beispiel Automatikgetriebesteuerungen eingesetzt wurden, die in aggressiven Medien eingesetzt werden sollten, Fehlfunktionen beobachtet.

Die Druckschrift DE 3612576 C1 offenbart ein Leiterbahnstanzgitter gemäß des Oberbegriffs von Anspruch 1.

Die Druckschriften DE 19804607 A1 und DE 102009047051 A1 offenbaren weitere Leiterbahnstanzgitter aus dem Stand der Technik.

### Offenbarung der Erfindung

Ausführungsformen der Erfindung ermöglichen ein Leiterbahnstanzgitter und ein hiermit ausgebildetes Getriebesteuergerät sowie eine vorteilhafte Fertigung eines Leiterbahnstanzgitters, bei dem ein Risiko, dass Fluide aufgrund von Undichtigkeiten in einer umhüllenden Umspritzung an Kernelemente des Leiterbahnstanzgitters gelangen und dort schädigend wirken, minimiert ist.

Gemäß einem ersten Aspekt der vorliegenden Erfindung wird ein umspritztes Leiterbahnstanzgitter vorgeschlagen, das ein Kernelement sowie erste und zweite Teilumspritzungen aufweist. Das Kernelement weist hierbei mehrere nebeneinander angeordnete längliche Leiterbahnen auf. Die ersten Teilumspritzungen sind durch ein erstes Umspritzen des Kernelements an ersten Teilbereichen des Kernelements gebildet. Die zweiten Teilumspritzungen sind durch ein zweites Umspritzen des Kernelements an zweiten Teilbereichen des Kernelements gebildet. Die ersten und die zweiten Teilumspritzungen bilden gemeinsam eine Gesamtumspritzung, die das Kernelement vollständig einhüllt. Das Leiterbahnstanzgitter zeichnet sich dabei dadurch aus, dass benachbarte erste Teilbereiche voneinander beabstandet sind und jede der ersten Teilumspritzungen jeweils nur eine einzelne Leiterbahn umgibt.

Gemäß einem zweiten Aspekt der Erfindung wird ein Verfahren zum Fertigen eines entsprechenden Leiterbahnstanzgitters vorgeschlagen, wobei in einzelnen Verfahrensschritten um ein bereitgestelltes Kernelement entsprechende erste und zweite Teilumspritzungen derart ausgebildet werden, dass in einem fertiggestellten Leiterbahnstanzgitters jede der ersten Teilumspritzungen jeweils nur eine einzelne Leiterbahn umgibt.

Ideen zu Ausführungsformen der Erfindung können unter anderem als auf den nachfolgend beschriebenen Erkenntnissen und Gedanken beruhend angesehen werden.

Wie einführend angegeben, wurden bei herkömmlichen Leiterbahnstanzgittern Funktionsstörungen beobachtet, insbesondere wenn diese beispielsweise zur Verschaltung von Komponenten eines Getriebesteuergeräts direkt im Inneren eines Getriebes angeordnet wurden und somit dem Angriff dortiger aggressiver Medien, insbesondere aggressiven Getriebeöls, ausgesetzt waren. Es wird vermutet, dass in diesen Leiterbahnstanzgittern Undichtigkeiten entstehen, beispielsweise in Form feiner Haarrisse, und an diesen Undichtigkeiten aggressive Medien bis ins Innere des umspritzten Leiterbahnstanzgitters gelangen können. Die aggressiven Medien können dort Bestandteile des Leiterbahnstanzgitters wie zum Beispiel die metallischen Leiterbahnen chemisch angreifen beziehungsweise sogar zersetzen. Alternativ oder ergänzend hierzu können in den eindringenden Medien Bestandteile enthalten sein, die für eine elektrisch Leitfähigkeit der Medien sorgen, so dass durch ein bis zum Inneren eines Leiterbahnstanzgitters vordringendes Medium schlimmstenfalls ein elektrischer Kurzschlusspfad gebildet werden kann. Aufgrund dieser Effekte können Leiterbahnen des Leiterbahnstanzgitters unterbrochen oder kurzgeschlossen werden, wodurch Fehlfunktionen der damit gebildeten Schaltung bewirkt werden können.

Es wird davon ausgegangen, dass die genannten Undichtigkeiten insbesondere in Bereichen angrenzend an die Erstumspritzung innerhalb des Leiterbahnstanzgitters auftreten können. Wie weiter unten im Detail erklärt werden wird, dient diese Erstumspritzung bisher unter anderem dazu, während der Herstellung eines Leiterbahnstanzgitters die in der gesamten Kunststoffumspritzung aufzunehmenden Leiterbahnen zeitweilig in Relation zueinander mechanisch zu fixieren. Bisher werden solche Erstumspritzungen meist als erste lokale Umspritzung mehrerer benachbarter Leiterbahnen ausgebildet und erstrecken sich somit in der gleichen Ebene wie die Leiterbahnen selbst. Am Übergang zu einer nachfolgend ausgebildeten zweiten Umspritzung können sich jedoch feine Spalte bilden, in die aggressive Medien eindringen können und bis zu den von der ersten Umspritzung zusammengehaltenen und von der zweiten Umspritzung eingehüllten Leiterbahnen gelangen können.

Es wurde nun erkannt, dass die genannte Problematik verhindert oder zumindest entschärft werden kann, indem die die Erstumspritzung bildenden ersten Teilumspritzungen derart ausgebildet oder zumindest nachbehandelt werden, dass an dem fertiggestellten umspritzten Leiterbahnstanzgitter jede der ersten Teilumspritzungen jeweils nur eine einzige Leiterbahn umgibt. Hierdurch unterscheidet sich das vorgeschlagene Leiterbahnstanzgitter von herkömmlichen Leiterbahnstanzgittern, bei denen die Erstumspritzung in der Regel mehrere benachbarte Leiterbahnen umgibt. Indem jede erste Teilumspritzung nur eine einzelne Leiterbahn umgibt, kann verhindert werden, dass sich angrenzend an eine erste Teilumspritzung ein Spalt bildet, der von einer Leiterbahn bis zu einer benachbarten Leiterbahn reicht. Entsprechend kann verhindert werden, dass sich in einem solchen Spalt leitfähige Medien wie zum Beispiel mit Metallionen versetztes Getriebeöl anreichern kann und so einen elektrisch leitenden Pfad zwischen benachbarten Leiterbahnen und letztendlich einen Kurzschluss zwischen diesen Leiterbahnen erzeugen kann.

Im fertigen umspritzten Leiterbahnstanzgitter können sich die ersten Teilumspritzungen wenigstens von einer der Leiterbahnen bis hin zu einer Außenoberfläche der Gesamtumspritzung erstrecken. Mit anderen Worten können die ersten Teilumspritzungen in der Gesamtumspritzung nach außen hin frei liegen. Dies ergibt sich unter anderem aus ihrem Zweck während der Bildung der Gesamtumspritzung, da sie beim Ausbilden der zweiten Teilumspritzungen das Kernelement innerhalb eines Spritzwerkzeugs halten sollen. Anlageflächen innerhalb des Spritzwerkzeugs liegen dabei an den ersten Teilumspritzungen an, so dass diese beim zweiten Teilumspritzen nicht mit umspritzt werden und somit letztendlich frei liegen.

Das Ziel, das jede erste Teilumspritzung jeweils nur eine einzelne Leiterbahn umgibt, kann fertigungstechnisch in unterschiedlicher Weise realisiert werden.

Beispielsweise kann jede der ersten Teilumspritzungen an den ersten Teilbereichen des Kernelements jeweils durch lokales Umspritzen einer einzelnen Leiterbahn bebildet werden. Mit anderen Worten kann bereits beim Ausbilden der ersten Teilumspritzungen ein Spritzguss beispielsweise durch Verwendung eines geeigneten Werkzeugs derart durchgeführt werden, dass jede der ersten spritzgegossenen Kunststoffbereiche jeweils nur eine einzelne Leiterbahn umgibt und nicht bis zu benachbarten Leiterbahnen reicht.

Alternativ können erste Teilumspritzungen durch lokales Umspritzen mehrerer benachbarter Leiterbahnen ausgebildet werden und anschließend eine derart gebildete Umspritzung in Bereichen zwischen benachbarten Leiterbahnen unterbrochen werden. Mit anderen Worten können beim Herstellen des Leiterbahnstanzgitters zunächst, ähnlich wie bei herkömmlichen Herstellungsverfahren, mehrere Leiterbahnen zusammen umspritzt werden und erst anschließend Bereiche einer solchen Umspritzung nachträglich wieder gezielt entfernt werden. Beispielsweise können solche Bereiche weggestanzt werden.

Die durch lokales Umspritzen mehrerer benachbarter Leiterbahnen gebildete Umspritzung kann vor oder alternativ nach dem Ausbilden der zweiten Teilumspritzungen in Bereichen zwischen benachbarten Leiterbahnen unterbrochen werden. Mit anderen Worten kann eine solche weiträumigere Erstumspritzung bereits in Bereichen zwischen benachbarten Leiterbahnen wieder entfernt werden, bevor die zweite Teilumspritzung ausgebildet wird oder alternativ erst nachdem eine solche zweite Teilumspritzung ausgebildet wurde. Beide Ausführungsvarianten können verfahrenstechnische Vorteile mit sich bringen.

Um das Kernelement und insbesondere die darin vorgesehenen Leiterbahnen während des Umspritzens zu stabilisieren, kann vor dem Ausbilden der zweiten Teilumspritzung an Endbereichen des Kernelements eine mehrere Leiterbahnen des Kernelements verbindende Stabilisierungsumspritzung ausgebildet werden. Prinzipiell kann eine solche Stabilisierungsumspritzung in einem separaten Spritzgussvorgang ausgebildet werden. Es kann jedoch bevorzugt sein, die Stabilisierungsumspritzung zusammen mit den ersten Teilumspritzungen auszubilden. Nachdem die zweiten Teilumspritzungen ausgebildet wurden und die Komponenten des Kernelements somit fest miteinander verbunden sind, kann eine solche Stabilisierungsumspritzung gegebenenfalls wieder entfernt werden.

Es wird darauf hingewiesen, dass mögliche Merkmale und Vorteile von Ausführungsformen der Erfindung hierin teilweise mit Bezug auf ein erfindungsgemäßes Leiterbahnstanzgitter und teilweise mit Bezug auf ein Verfahren zum Fertigen eines solchen Leiterbahnstanzgitters beschrieben sind. Ein Fachmann erkennt, dass die beschriebenen Merkmale in geeigneter Weise kombiniert beziehungsweise ausgetauscht werden können, um zu weiteren Ausführungsformen und gegebenenfalls Synergieeffekten zu gelangen.

### Kurze Beschreibung der Zeichnungen

Nachfolgend werden Ausführungsformen der Erfindung unter Bezugnahme auf die beigefügten Zeichnungen beschrieben, wobei weder die Beschreibung noch die Zeichnungen als die Erfindung einschränkend auszulegen sind.
Figur 1 zeigt in Draufsicht durch Stege und eine Erstumspritzung verbundene Leiterbahnen eines herkömmlichen Leiterbahnstanzgitters vor einem zweiten Umspritzen.
Figur 2 zeigt eine Schnittansicht D-D des Leiterbahnstanzgitters aus Figur 3 nach dem zweiten Umspritzen.
Figuren 3 bis 5 zeigen Querschnittsansichten entlang der Schnitte A-A, B-B und C-C aus Figur 2.
Figuren 6 bis 9 zeigen jeweils in Draufsicht Komponenten eines Leiterbahnstanzgitters in einer Sequenz von Verfahrensschritten eines Fertigungsverfahrens gemäß verschiedenen Ausführungsformen der vorliegenden Erfindung.

Die Figuren sind lediglich schematisch und nicht maßstabsgetreu. Gleiche Bezugszeichen bezeichnen in den verschiedenen Figuren gleiche oder gleichwirkende Merkmale.

### Ausführungsformen der Erfindung

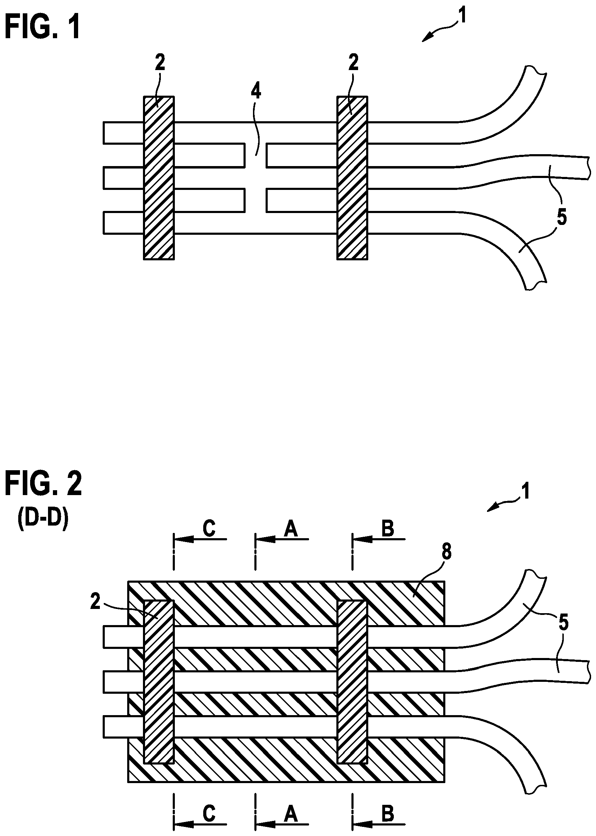

Mit Bezug auf die Figuren 1 bis 5 werden zunächst Merkmale eines herkömmlichen Leiterbahnstanzgitters sowie eines Verfahren zu dessen Fertigung beschrieben.

Zunächst werden in einem ersten Fertigungsschritt Leiterbahnen 5 des Leiterbahnstanzgitters 1 mittels Stanzverfahren gebildet, beispielsweise durch Herausstanzen aus einem Metallblech. Dabei sind die einzelnen Leiterbahnen 5 an einigen Stellen durch Stege 4 miteinander verbunden, so dass nicht jede einzelne Leiterbahn 5 während eines nachfolgenden Umspritzungsvorganges in ein entsprechendes Werkzeug eingelegt werden muss.

Anschließend werden die Leiterbahnen 1 mit einem Kunststoff umspritzt, um erste Teilumspritzungen 2 zu bilden. Diese ersten Teilumspritzungen 2 fixieren die damit verbundenen Leiterbahnen 5 in Bezug zu einander, nachdem die zuvor verbindenden Stege 4 durch Freistanzen entfernt wurden.

Die derart vorbereiteten und durch erste Teilumspritzungen 2 gehaltenen Leiterbahnen 5 werden dann in ein geeignetes Umspritzwerkzeug eingelegt, in dem sie mit einer zweiten Teilumspritzung 8 aus elektrisch isolierendem Kunststoff umspritzt werden (Figur 2). Um die Leiterbahnen 5 beidseitig umspritzen zu können, werden diese dabei innerhalb des Umspritzwerkzeugs über Noppen, die sich an den ersten Teilumspritzungen 2 abstützen, gehalten.

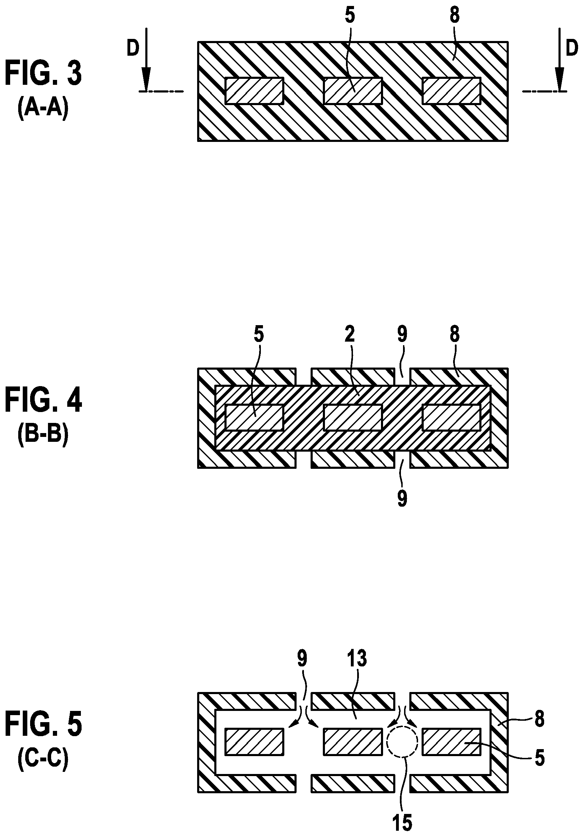

Die zweite Teilumspritzung 8 umgibt die Leiterbahnen 5 in weiten Bereichen vollständig, wie in der in Figur 3 dargestellten Schnittdarstellung entlang der Linien A-A veranschaulicht. Die Linie D-D in Figur 3 gibt dabei an, entlang welcher Ebene die Draufsicht aus Figur 2 dargestellt ist.

In Figur 4 ist eine Schnittansicht entlang der Ebene B-B aus Figur 2 dargestellt. Die Leiterbahnen 5 sind dabei von der ersten Teilumspritzung 2 umschlossen und diese erste Teilumspritzung 2 ist wiederum von der zweiten Teilumspritzung 8 umgeben. Allerdings ist die zweite Teilumspritzung 8 dabei in den Bereichen 9, in denen sich beim Umspritzen die Noppen des Umspritzwerkzeuges an den ersten Teilumspritzungen 2 abstützen, lokal unterbrochen.

Figur 5 zeigt eine Schnittansicht entlang der Ebene C-C aus Figur 2, das heißt direkt an einer Kante einer ersten Teilumspritzung 2. An dieser Kante befindet sich ein Übergang zwischen dem Material der ersten Teilumspritzung 2 und dem Material der zweiten Teilumspritzung 8. Diese Materialien sowie das Material der Leiterbahnen 5 können unterschiedliche Wärmeausdehnungskoeffizienten haben, so dass sich in diesem Bereich aufgrund von Temperaturschwankungen mikroskopische kleine Spalte 13 bilden können, in die über die nach außen hin frei liegenden Bereiche 9 zum Beispiel aggressive Medien ins Innere der Umspritzung eindringen und bis hin zu den Leiterbahnen 5 gelangen können. Im Inneren der zweiten Teilumspritzung 8 können die eingedrungenen Medien dabei für lange Zeit verweilen und dabei beispielsweise die Leiterbahnen 5 angreifen und / oder sich chemisch umwandeln und / oder Ablagerungen bilden.

Insbesondere in Regionen 15 zwischen benachbarten Leiterbahnen 1 können solche Vorgänge dahingehend nachteilig wirken, dass beispielsweise leitfähige Reaktionsprodukte eine elektrische Verbindung zwischen den benachbarten Leiterbahnen 1 bilden können und es somit zu lokalen Kurzschlüssen kommen kann.

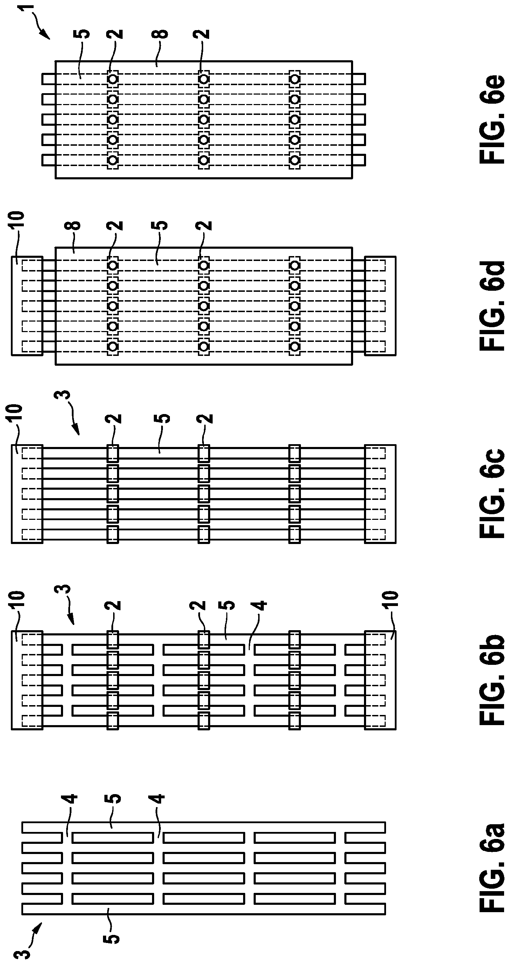

Unter Bezugnahme auf die Figuren 6 bis 9 werden nun Ausführungsformen eines erfindungsgemäßen Verfahrens zum Fertigen eines erfindungsgemäßen Leiterbahnstanzgitters beschrieben.

Wie in Figur 6(a) dargestellt, wird zunächst ein Kernelement 3 mit mehreren nebeneinander angeordneten länglichen Leiterbahnen 5 bereitgestellt. Die Leiterbahnen 5 sind dabei durch Stege 4 miteinander verbunden. Das gesamte Kernelement 3 kann beispielsweise aus einem Blech ausgestanzt sein und somit einstückig sein.

Im nachfolgenden Verfahrensschritt werden, wie in Figur 6(b) dargestellt, erste Teilumspritzungen 2 an ersten Teilbereichen des Kernelements 3 ausgebildet. Hierzu wird das Kernelement 3 in ein geeignetes Spritzgusswerkzeug eingelegt, welches in den ersten Teilbereichen, in denen die ersten Teilumspritzungen 2 zu bilden sind, geeignete Hohlräume aufweist, in die dann flüssiger Kunststoff eingespritzt wird. Der flüssige Kunststoff sollte hierbei elektrisch nicht leitfähig sein und kann beispielsweise PEEK sein. Gleichzeitig mit dem Ausbilden der ersten Teilumspritzungen 2 werden an den beiden gegenüber liegenden Enden des Kernelements 3 Stabilisierungsumspritzungen 10 ausgebildet, die mehrere benachbarte Leiterbahnen 5 umschließen und diese mechanisch stabilisierend miteinander verbinden.

In einem nachfolgenden Verfahrensschritt werden die Stege 4 entfernt, beispielsweise durch lokales Wegstanzen, wie in Figur 6(c) gezeigt.

Anschließend wird in einem zweiten Spritzgussprozess das Kernelement 3 zusammen mit den daran ausgebildeten ersten Teilumspritzungen 2 in ein geeignetes Spritzgusswerkzeug aufgenommen und durch Einspritzen von Kunststoff zweite Teilumspritzungen 8 gebildet, wie in Figur 6(d) gezeigt. Das Kernelement 3 wird dabei über die ersten Teilumspritzungen 2 innerhalb des Spritzgusswerkzeugs gehalten, so dass diese Bereiche nicht mit umspritzt werden und die ersten Teilumspritzungen 2 anschließend nach außen hin frei liegen. Der Rest des Kernelements 3 ist jedoch zumindest in einem Zentralbereich, das heißt mit Ausnahme der Enden der Leiterbahnen 5, vollständig von den zweiten Teilumspritzungen 8 umschlossen, so dass die ersten und die zweiten Teilumspritzungen 2, 8 zusammen das Kernelement 3 vollständig einhüllen, wie dies in Figur 6(d) gezeigt ist.

Abschließend können die Stabilisierungsumspritzungen 10 entfernt werden, beispielsweise durch Abstanzen, wie in Figur 6(e) gezeigt.

Bei dem derart hergestellten fertigen umspritzten Leiterbahnstanzgitter 1 sind die länglichen Leiterbahnen 5 vollständig in der Gesamtumspritzung aufgenommen. An Grenzflächen zwischen den ersten Teilumspritzungen 2 und den zweiten Teilumspritzungen 8 können sich zwar beispielsweise durch thermische Ausdehnung Spalte bilden, in die Fluide eindringen können. Da jedoch jeder der ersten Teilbereiche 2 lediglich in Kontakt mit einer einzelnen Leiterbahn 5 steht, können sich diese Spalte nicht zwischen benachbarten Leiterbahnen 5 erstrecken und somit keine Kurzschlüsse über darin bewirktes leitfähiges Fluid bewirkt werden.

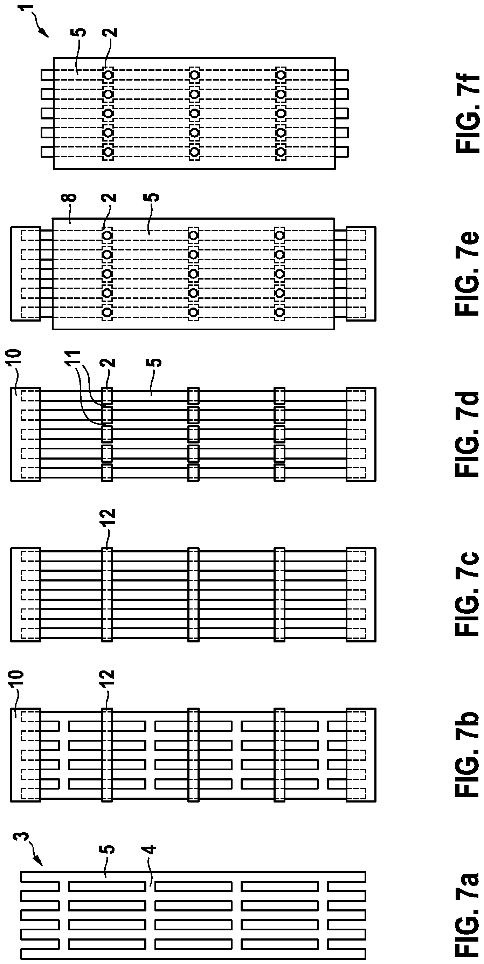

Bei den in den Figuren 7, 8 und 9 dargestellten Ausführungsbeispielen werden, wie in den jeweiligen Figuren (b) dargestellt bei einer Vorumspritzung zunächst mehrere benachbarte Leiterbahnen 5 gemeinsam umspritzt, wodurch Halteumspritzungen 12 gebildet werden. Nach einer solchen Vorumspritzung sind benachbarte Leiterbahnen 5 relativ zueinander gehalten und können somit gut als Einheit in einem nachfolgenden Stanzvorgang oder Umspritzungsvorgang verarbeitet werden.

Wie in Figur 7(d) dargestellt, können dabei Bereiche 11 der Halteumspritzung 12 zwischen benachbarten Leiterbahnen 5 beispielsweise durch lokales Freistanzen unterbrochen werden. Anschließend können in einem weiteren Spritzgussvorgang, wie in Figur 7(e) dargestellt, die zweiten Teilumspritzungen 8 ausgebildet werden.

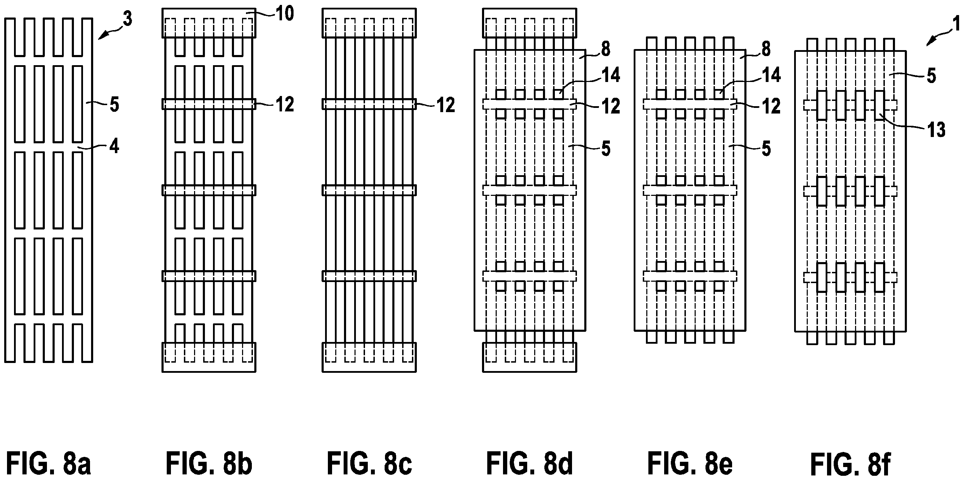

Alternativ können, wie bei der in Figur 8 dargestellten Ausgestaltung veranschaulicht, zunächst die Zweitumspritzungen 8 ausgebildet werden (siehe Figur 8(d)) und erst nachträglich die zunächst durchgängig ausgebildeten Halteumspritzungen 12 lokal zwischen benachbarten Leiterbahnen 5 unterbrochen werden. Hierzu können in der Zweitumspritzung 8 an Positionen zwischen benachbarten Leiterbahnen 5 Öffnungen 14 vorgesehen sein, durch die hindurch die Halteumspritzung 12 lokal freigestanzt werden kann (siehe Figur 8(f)).

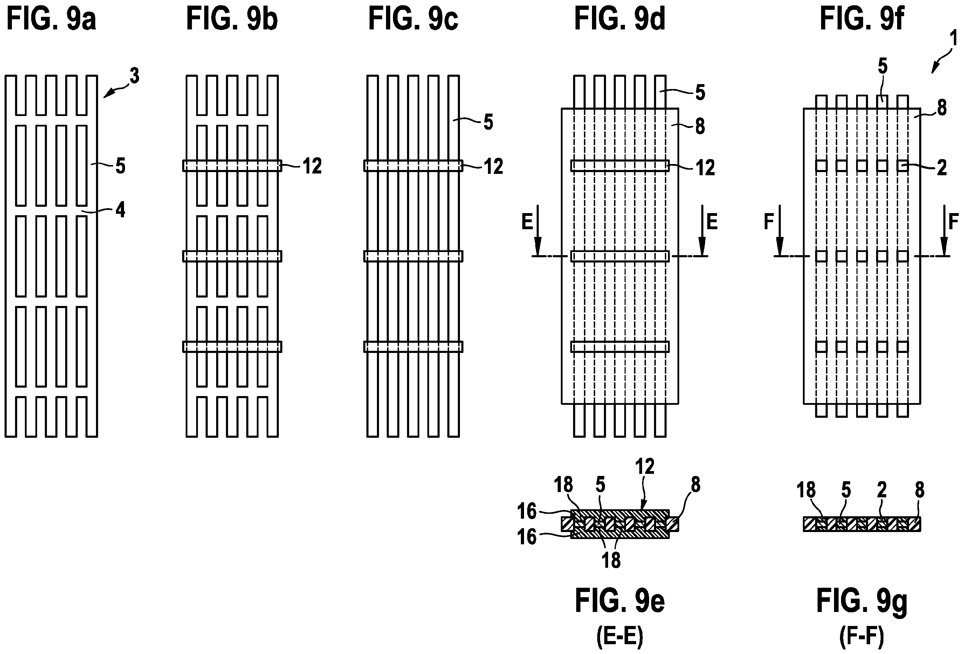

Bei der in Figur 9 dargestellten Herstellungssequenz ist die Halteumspritzung 12 derart ausgebildet, dass sie nach Bildung der Zweitumspritzung 8 nach außen über diese hinaus (d.h. aus der Zeichenebene heraus) absteht, wie im Querschnitt in Fig. 9(e) dargestellt. Während des Freistanzens der Stege (siehe Figur 9(c)) sowie während des Ausbildens der Zweitumspritzungen (siehe Figur 9(d)) sind die Leiterbahnen 5 über die Halteumspritzung 12 stabil relativ zueinander gehalten. Die Halteumspritzung 12 ist dabei derart ausgestaltet, dass von einem durchgehende Teil 16, der parallel zu einer Oberfläche der Zweitumspritzung 8 verläuft, mehrere Fortsätze 18 jeweils in die Zweitumspritzung 8 hinein ragen und dort bis zu den Leiterbahnen 5 reichen und diese umschließen. Jeder der Fortsätze 18 umschließt dabei nur eine einzelne Leiterbahn 5. Nach dem Ausbilden der Zweitumspritzung 8 (Figur 9(d)) kann anschließend gegebenenfalls der nach außen hin freiliegende, durchgehende Teil 16 der Halteumspritzung 12 abgetrennt werden, wie in Figur 9(f) sowie im Querschnitt in Figur 9(g) gezeigt, so dass über die Halteumspritzung 12 keine durchgängige Verbindung mehr zwischen benachbarten Leiterbahnen 5 entstehen kann.

## Patentansprüche

1. Umspritztes Leiterbahnstanzgitter (1) aufweisend:
ein Kernelement (3) mit mehreren nebeneinander angeordneten länglichen Leiterbahnen (5);
durch ein erstes Umspritzen des Kernelements (3) gebildete erste Teilumspritzungen (2) an ersten Teilbereichen des Kernelements (3);
durch ein zweites Umspritzen des Kernelements (3) gebildete zweite Teilumspritzungen (8) an zweiten Teilbereichen des Kernelements (3);
wobei die ersten und die zweiten Teilumspritzungen (2, 8) gemeinsam eine Gesamtumspritzung bilden, die das Kernelement (3) vollständig einhüllt;
**dadurch gekennzeichnet, dass**
benachbarte erste Teilbereiche voneinander beabstandet sind und jede der ersten Teilumspritzungen (2) jeweils nur eine einzelne Leiterbahn (5) umgibt.

2. Umspritztes Leiterbahnstanzgitter nach Anspruch 1, wobei die ersten Teilumspritzungen (2) sich wenigstens von einer der Leiterbahnen (5) bis zu einer Außenoberfläche der Gesamtumspritzung erstrecken.

3. Verfahren zum Fertigen eines Leiterbahnstanzgitters (1), aufweisend:
Bereitstellen eines Kernelements (3) mit mehreren nebeneinander angeordneten länglichen Leiterbahnen (5);
Ausbilden von ersten Teilumspritzungen (2) an ersten Teilbereichen des Kernelements (3);
Ausbilden von zweiten Teilumspritzungen (8) an zweiten Teilbereichen des Kernelements (3);
wobei die ersten und die zweiten Teilumspritzungen (2, 8) gemeinsam eine Gesamtumspritzung bilden, die das Kernelement (3) vollständig einhüllt;
**dadurch gekennzeichnet, dass**
benachbarte erste Teilbereiche voneinander beabstandet sind und jede der ersten Teilumspritzungen (2) jeweils nur eine einzelne Leiterbahn (5) umgibt.

4. Verfahren nach Anspruch 3, wobei jede der ersten Teilumspritzungen (2) an den ersten Teilbereichen des Kernelements (3) jeweils durch lokales Umspritzen einer einzelnen Leiterbahn (5) gebildet wird.

5. Verfahren nach Anspruch 3, wobei die ersten Teilumspritzungen (2) an den ersten Teilbereichen des Kernelements (1) durch lokales Umspritzen mehrerer benachbarter Leiterbahnen (5) und anschließendes Unterbrechen einer derart gebildeten Halteumspritzung (12) in Bereichen zwischen benachbarten Leiterbahnen (5) gebildet werden.

6. Verfahren nach Anspruch 5, wobei die Halteumspritzung (12) vor dem Ausbilden der zweiten Teilumspritzungen (8) in Bereichen zwischen benachbarten Leiterbahnen (5) unterbrochen wird.

7. Verfahren nach Anspruch 5, wobei die Halteumspritzung (12) nach dem Ausbilden der zweiten Teilumspritzungen (8) in Bereichen zwischen benachbarten Leiterbahnen (5) unterbrochen wird.

8. Verfahren nach einem der Ansprüche 3 bis 7, wobei vor dem Ausbilden der zweiten Teilumspritzungen (8) an Endbereichen des Kernelements (3) eine mehrere Leiterbahnen (5) des Kernelements (3) verbindende Stabilisierungsumspritzung (10) ausgebildet wird.

9. Getriebesteuergerät mit einem umspritzten Leiterbahnstanzgitter (1) nach einem der Ansprüche 1 oder 2 oder mit einem gemäß einem der Ansprüche 3 bis 8 gefertigten umspritzten Leiterbahnstanzgitter (1).

## Claims

1. Insert-molded lead frame (1) having:
a core element (3) with a plurality of elongate conductor tracks (5) arranged next to one another;
first partial insert-moldings (2), which are formed by a first insert molding of the core element (3), on first partial regions of the core element (3);
second partial insert-moldings (8), which are formed by a second insert molding of the core element (3), on second partial regions of the core element (3);
wherein the first and the second partial insert moldings (2, 8) together form a complete insert-molding which completely encases the core element (3);
**characterized in that**
adjacent first partial regions are spaced apart from one another, and each of the first partial insert-moldings (2) in each case surrounds only one individual conductor track (5).

2. Insert-molded lead frame according to Claim 1, wherein the first partial insert-moldings (2) extend at least from one of the conductor tracks (5) as far as an outer surface of the complete insert-molding.

3. Method for the production of a lead frame (1), comprising:
providing a core element (3) with a plurality of elongate conductor tracks (5) arranged next to one another;
forming first partial insert-moldings (2) on first partial regions of the core element (3);
forming second partial insert-moldings (8) on second partial regions of the core element (3);
wherein the first and the second partial insert-moldings (2, 8) together form a complete insert-molding which completely encases the core element (3) ;
**characterized in that**
adjacent first partial regions are spaced apart from one another, and each of the first partial insert-moldings (2) in each case surrounds only one individual conductor track (5).

4. Method according to Claim 3, wherein each of the first partial insert-moldings (2) is formed on the first partial regions of the core element (3) by local insert molding of an individual conductor track (5) in each case.

5. Method according to Claim 3, wherein the first partial insert-moldings (2) are formed on the first partial regions of the core element (1) by local insert molding of a plurality of adjacent conductor tracks (5) and subsequent interruption of a retaining insert-molding (12) formed in such a manner in regions between adjacent conductor tracks (5).

6. Method according to Claim 5, wherein the retaining insert-molding (12) is interrupted in regions between adjacent conductor tracks (5) before the second partial insert-moldings (8) are formed.

7. Method according to Claim 5, wherein the retaining insert-molding (12) is interrupted in regions between adjacent conductor tracks (5) after the second partial insert-moldings (8) are formed.

8. Method according to one of Claims 3 to 7, wherein a stabilizing insert-molding (10) connecting a plurality of conductor tracks (5) of the core element (3) is formed on end regions of the core element (3) before the second partial insert-moldings (8) are formed.

9. Transmission control device with an insert-molded lead frame (1) according to either of Claims 1 and 2 or with an insert-molded lead frame (1) produced according to one of Claims 3 to 8.

## Revendications

1. Grille estampée de tracés conducteurs surmoulée par injection (1) présentant:
un élément de noyau (3) avec plusieurs tracés conducteurs allongés (5) agencés l'un à côté de l'autre;
des premiers surmoulages partiels (2) formés par un premier surmoulage de l'élément de noyau (3) sur des premières zones partielles de l'élément de noyau (3);
des deuxièmes surmoulages partiels (8) formés par un deuxième surmoulage de l'élément de noyau (3) sur des deuxièmes zones partielles de l'élément de noyau (3);
dans laquelle les premiers et les deuxièmes surmoulages partiels (2, 8) forment ensemble un surmoulage global, qui enrobe entièrement l'élément de noyau (3);
**caractérisée en ce que** des premières zones partielles voisines sont espacées l'une de l'autre et chacun des premiers surmoulages partiels (2) n'entoure chaque fois qu'un seul tracé conducteur (5).

2. Grille estampée de tracés conducteurs surmoulée par injection selon la revendication 1, dans laquelle les premiers surmoulages partiels (2) s'étendent au moins depuis un des tracés conducteurs (5) jusqu'à une surface extérieure du surmoulage global.

3. Procédé de fabrication d'une grille estampée de tracés conducteurs (1), comprenant les étapes suivantes:
préparer un élément de noyau (3) avec plusieurs tracés conducteurs allongés (5) agencés l'un à côté de l'autre;
former des premiers surmoulages partiels (2) sur des premières zones partielles de l'élément de noyau (3);
former des deuxièmes surmoulages partiels (8) sur des deuxièmes zones partielles de l'élément de noyau (3);
dans lequel les premiers et les deuxièmes surmoulages partiels (2, 8) forment ensemble un surmoulage global, qui enrobe entièrement l'élément de noyau (3);
**caractérisé en ce que** des premières zones partielles voisines sont espacées l'une de l'autre et chacun des premiers surmoulages partiels (2) n'entoure chaque fois qu'un seul tracé conducteur (5).

4. Procédé selon la revendication 3, dans lequel on forme chacun des premiers surmoulages partiels (2) sur les premières zones partielles de l'élément de noyau (3) respectivement par un surmoulage local d'un seul tracé conducteur (5).

5. Procédé selon la revendication 3, dans lequel on forme les premiers surmoulages partiels (2) sur les premières zones partielles de l'élément de noyau (1) par surmoulage local de plusieurs tracés conducteurs voisins (5) et ensuite interruption d'un surmoulage de maintien ainsi formé (12) dans des régions situées entre des tracés conducteurs voisins (5).

6. Procédé selon la revendication 5, dans lequel on interrompt le surmoulage de maintien (12) avant la formation des deuxièmes surmoulages partiels (8) dans des régions situées entre des tracés conducteurs voisins (5).

7. Procédé selon la revendication 5, dans lequel on interrompt le surmoulage de maintien (12) après la formation des deuxièmes surmoulages partiels (8) dans des régions situées entre des tracés conducteurs voisins (5).

8. Procédé selon l'une quelconque des revendications 3 à 7, dans lequel on forme un surmoulage de stabilisation (10) reliant plusieurs tracés conducteurs (5) de l'élément de noyau (3) sur des régions d'extrémité de l'élément de noyau (3) avant la formation des deuxièmes surmoulages partiels (8).

9. Appareil de commande de boîte de vitesses comportant une grille estampée de tracés conducteurs surmoulée par injection (1) selon une des revendications 1 ou 2 ou une grille estampée de tracés conducteurs surmoulée par injection (1) fabriquée selon l'une quelconque des revendications 3 à 8.
